# FASCICULE DE BREVET EUROPEEN

(11) **EP 3 361 851 B1**
(45) Date de publication et mention de la délivrance du brevet: **23.06.2021**
(21) Numéro de dépôt: 18156353.7
(22) Date de dépôt: 12.02.2018
(51) Int. Cl.: H05K 9/00

(54) **STRUCTURE DE BLINDAGE ELECTROMAGNETIQUE POUR CARTES ELECTRONIQUES**
ELEKTROMAGNETISCHE ABSCHIRMSTRUKTUR FÜR ELEKTRONISCHE KARTEN
ELECTROMAGNETIC SHIELDING STRUCTURE FOR ELECTRONIC CARDS

(30) Priorité: 13.02.2017 FR 1751162
(43) Date de publication de la demande: 15.08.2018
(73) Titulaire: Commissariat à l'énergie atomique et aux énergies alternatives, 75015 Paris (FR)
(72) Inventeur: SIMONATO, Jean-Pierre, 38360 SASSENAGE (FR); CELLE, Caroline, 42700 FIRMINY (FR)
(74) Mandataire: Brevalex

(56) Documents cités:
- EP-A2- 2 500 171
- WO-A1-2015/046063
- WO-A1-2015/083491
- JP-A- 2003 273 562
- US-A1- 2014 268 625
- US-A1- 2016 066 481
- US-B1- 9 545 043

## Description

### DOMAINE TECHNIQUE ET ETAT DE LA TECHNIQUE ANTERIEURE

La présente invention concerne une structure de blindage électromagnétique pour cartes électroniques et son procédé de réalisation.

Les cartes électroniques ou circuits imprimés sont formés de différents composants électroniques, tels que des microprocesseurs, des mémoires, ou des bus, par exemple, disposés sur une plaque et reliés électriquement entre eux. Pour protéger les composants électroniques du champ électromagnétique, des radiofréquences et des parasites électriques, un blindage électromagnétique est déposé sur la carte électronique. Le blindage électromagnétique forme une barrière physique, électriquement conductrice, entre la source électromagnétique et les éléments potentiellement sensibles à protéger.

Les dispositifs de blindage sont, classiquement, sous la forme de boîtiers de blindages (aussi appelés « cages » de blindage). Les boîtiers sont réalisés en utilisant des feuilles de métal ou des grilles de métal qui recouvrent les éléments sensibles. Les boîtiers peuvent être fixés sur les cartes électroniques, par exemple avec des clips de fixation ou de vissage, ou encore grâce à une soudure. Ces systèmes de fixation nécessitent généralement une mise en œuvre complexe et longue.

De plus, ce type de boîtiers présente un encombrement assez important et est plutôt adapté pour des cartes électroniques présentant une surface plane et une forme géométrique simple, par exemple carrée ou rectangulaire.

Les documents WO 2015/083491 et US 2014/268625 décrivent des structures électromagnétiques pour dispositif électronique comprenant un matériau de base formé d'éléments métalliques dispersés dans une résine ou un matériau polymère.

### EXPOSÉ DE L'INVENTION

C'est, par conséquent, un but de la présente invention de proposer une structure de blindage électromagnétique peu encombrante et légère.

C'est un autre but de la présente invention de proposer une structure de blindage pouvant être disposée sur des cartes électroniques de tailles et formes variées.

Ces buts sont atteints par une structure de blindage électromagnétique selon la revendication 1.

Par « matériau polymère », on entend un matériau formé d'un polymère ou d'un copolymère.

Les nanofils forment un réseau percolant conducteur électrique semi-transparent. Par réseau percolant, on entend que les nanofils forment un chemin continu tout au long du film de blindage de manière à pouvoir conduire électriquement les charges d'un bout à l'autre du film de blindage. Par semi-transparent, on entend que le réseau de nanofils a une transmittance supérieure à 50 % dans le domaine visible, i.e. de 350nm à 750nm, et de préférence supérieure à 70 % dans le domaine visible.

Le film de blindage contient au moins 90 % de nanofils métalliques. Il peut contenir jusqu'à 10 % massique d'éléments additionnels. Les éléments additionnels sont électriquement conducteurs.

Selon une première variante, le film de blindage comprend, en outre, des nanotubes de carbone et/ou du graphène.

Selon une autre variante, le film de blindage est constitué de nanofils métalliques.

Avantageusement, le film de blindage a une épaisseur allant de 20nm à 1000nm et de préférence de 20nm à 300nm.

Les nanofils sont des nanofils d'un métal noble, ou d'un alliage de métaux nobles, d'un métal, ou d'un alliage de métaux, ou encore d'un alliage d'un métal et d'un métal noble. Préférentiellement, les nanofils sont des nanofils d'argent, d'or, de cuivre ou de nickel.

Par nanofils d'argent, par exemple, on entend que plus de 80 % des nanofils sont des nanofils d'argent. Par exemple, pour les nanofils dits « d'argent », 90 % des nanofils peuvent être des nanofils d'argent, et 10 % de nanofils peuvent être des nanofils d'un autre métal, comme le cuivre.

Avantageusement, la masse surfacique de nanofils est de 10mg/m² à 1000mg/m², plus avantageusement de 20mg/m² à 400mg/m², et encore plus avantageusement de 30mg/m² à 50mg/m², ce qui permet de réduire la quantité de matière première utilisée, notamment dans le cas des métaux précieux. Le coût de fabrication est alors réduit tout en offrant une bonne conduction électrique, et un blindage électromagnétique efficace.

Avantageusement, le diamètre moyen des nanofils est inférieur à 200nm, et de préférence inférieur à 100 nm, et la longueur moyenne des nanofils est de 1µm à 500µm.

Avantageusement, la couche de protection assure la tenue mécanique du réseau de nanofils. En outre, elle peut protéger les nanofils de l'atmosphère, et plus particulièrement des risques de dégradation chimique, par exemple des réactions d'oxydation ou de sulfuration.

Avantageusement, le premier matériau polymère est un polysiloxane, un polyépoxyde, un polyacrylique ou un polyuréthane.

Avantageusement, le second matériau polymère est un polysiloxane, un polyépoxyde, un polyacrylique ou un polyuréthane.

Avantageusement, la couche électriquement isolante et la couche de protection ont une épaisseur allant de 1µm à 5000µm, et de préférence, de 1µm à 1000µm.

Avantageusement, la structure de blindage est semi-transparente. Il est possible de visualiser les éléments sensibles à travers la structure de blindage.

L'invention concerne également un support comprenant une zone de composants électroniques à protéger et une piste de masse, recouvert par la structure de blindage telle que définie ci-dessus,
la couche électriquement isolante recouvrant au moins la zone de composants électroniques à protéger,
le film de blindage électromagnétique étant disposé sur la zone de composants électroniques et se prolongeant jusqu'à la piste de masse, de manière à réaliser une prise de contact sur la piste de masse, le film de blindage électromagnétique étant électriquement isolé de la zone de composants électroniques à protéger par la couche électriquement isolante,
la couche de protection recouvrant le film de blindage.

Avantageusement, le support est une carte électronique.

L'invention concerne également un procédé de réalisation d'une structure de blindage électromagnétique selon la revendication 11.

La solution comprenant les nanofils est, avantageusement, homogène, les nanofils sont bien dispersés dans le solvant, ce qui garantit la qualité du réseau percolant formé après évaporation du solvant.

Avantageusement, le premier matériau polymère est un polysiloxane, un polyépoxyde, un polyacrylique ou un polyuréthane.

Avantageusement, la couche électriquement isolante a une transmittance supérieure à 70 % dans le domaine visible. Les éléments sensibles à protéger sont visibles à travers la couche électriquement isolante, ce qui facilite le positionnement du film de blindage. Le matériau polymère et l'épaisseur de la couche électriquement isolante seront choisis de telle sorte que la couche électriquement isolante ait une transparence voulue.

Avantageusement, le second matériau polymère est un polysiloxane, un polyépoxyde, un polyacrylique ou un polyuréthane.

Ces polymères peuvent être dispersés dans des solvants. Une fois dispersé en solution, leur viscosité est plus faible et leur dépôt est facilité. La formation de la couche peut être réalisée en dispersant le polymère dans le solvant, en appliquant la solution sur un support et en évaporant le solvant.

Avantageusement, la couche électriquement isolante et la couche de protection sont formées par une technique de dépôt sans contact, tel qu'un dépôt par pulvérisation ou par enduction en rideau.

Le film de blindage peut être réalisé à travers un masque ou par dépôt par pulvérisation localisé. Seule la zone à protéger est recouverte, ce qui limite la consommation de nanofils et les coûts de réalisation.

De manière très avantageuse, un tel procédé peut être réalisé à température ambiante et à pression ambiante, ce qui facilite sa mise en œuvre et autorise l'utilisation de substrat plastique ou polymère.

Par température ambiante, on entend une température de l'ordre de 20-25°C et par pression ambiante, on entend une pression de l'ordre de 1bar.

### BRÈVE DESCRIPTION DES DESSINS

La présente invention sera mieux comprise sur la base de la description qui va suivre et des dessins en annexe sur lesquels :
- la figure 1 est une vue, en coupe et de profil, d'un support comprenant une zone de composants protégée par une structure de blindage électromagnétique selon un premier mode de réalisation de l'invention,
- la figure 2 est une vue, en coupe et de profil, d'un support comprenant une zone de composants protégée par une structure de blindage électromagnétique selon un deuxième mode de réalisation de l'invention,
- la figure 3 est une vue de dessus d'un support comprenant une zone de composants non protégée et deux zones de composants protégées chacune par une structure de blindage électromagnétique selon un troisième mode de réalisation de l'invention,
- la figure 4 est une vue de dessus d'un support comprenant deux zones de composants protégées par une même structure de blindage électromagnétique selon un quatrième mode de réalisation de l'invention,
- la figure 5 est une vue, en coupe et de profil, d'un support comprenant deux zones de composants protégées par une même structure de blindage électromagnétique selon un cinquième mode de réalisation de l'invention,
- la figure 6 est une vue de dessus d'un film de blindage électriquement conducteur, selon un mode de réalisation particulier de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et pouvant se combiner entre elles.

### EXPOSÉ DÉTAILLÉ DE MODES DE RÉALISATION PARTICULIERS

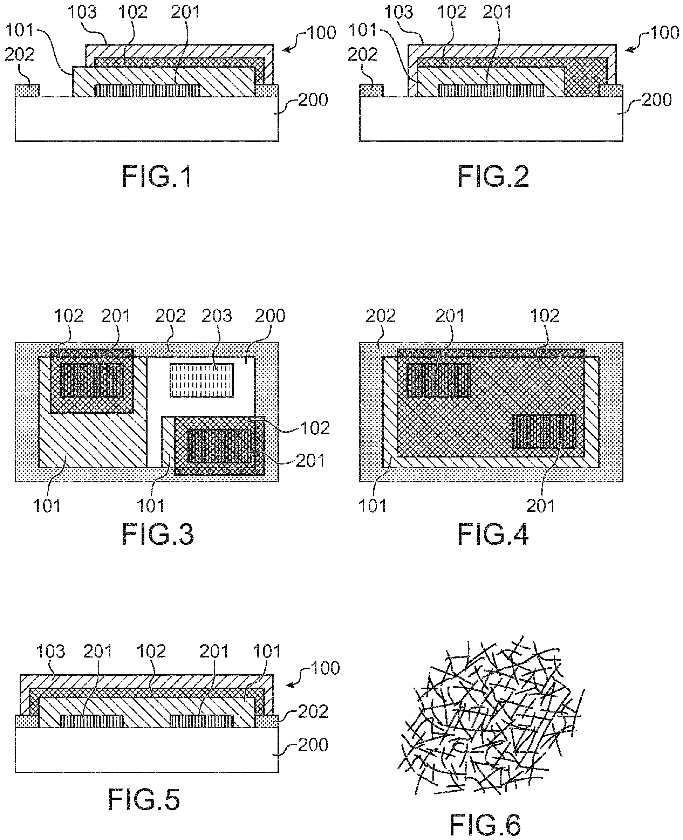

On se réfère tout d'abord aux figures 1 à 5 qui représentent une structure de blindage électromagnétique 100 sur un support 200 comportant au moins une zone de composants 201, dits « sensibles », à protéger.

### Le support 200 :

Le support 200 comprend des composants à protéger et une piste de masse 202.

Le support 200 a, par exemple, une forme rectangulaire. Il pourrait, cependant, avoir une autre forme, carrée par exemple. Le support 200 peut être plan. Selon une variante, il n'est pas plan, c'est-à-dire que le support 200 présente des courbures, des inégalités de niveau, indépendamment de la présence des composants électroniques.

Le support 200 est, par exemple, une carte électronique. Les composants de la carte électronique peuvent être par exemple des microprocesseurs, des mémoires, des composants d'entrée et de sortie, des condensateurs, des résistances, des convertisseurs, ou des bus. Les composants peuvent être de même taille ou de tailles différentes.

Le support 200 peut comporter une seule zone de composants 201 à protéger (figures 1, 2) ou une pluralité de zones de composants à protéger (figures 3, 4, 5). La zone à protéger peut comporter un seul composant ou une pluralité de composants. La zone de composants 201 à protéger peut représenter une surface de quelques mm² ou de quelques cm² selon le nombre de composants présents dans la zone. Il est parfois nécessaire de recouvrir tous les composants du support 200, ce qui peut représenter une surface de quelques dm².

Le support peut également comporter une ou plusieurs zones de composants qui n'ont pas besoin d'être protégées 203 (figure 3).

Chaque zone 201 à protéger peut être recouverte par sa propre structure de blindage 100 (figure 3) ou par une structure de blindage 100 commune (figures 4 et 5). Chaque structure de blindage 100 est connectée à la piste de masse 202.

La piste de masse 202 est reliée à la masse du support 200. La piste de masse 202 est, par exemple, un anneau métallique, appelé anneau de garde. La piste de masse 202 est, par exemple, en or. Comme représenté sur les figures 1 à 5, la piste de masse 202 suit tout le contour du support. Elle pourrait, selon une variante non représentée, ne suivre qu'une partie du pourtour. Sur les différentes figures, la piste de masse 202 est sur le support 200, selon une variante, elle pourrait être incrustée dans le support 200.

### La structure de blindage électromagnétique 100 :

La structure de blindage électromagnétique 100 est formée successivement par :
- une couche électriquement isolante 101 en un premier matériau polymère,
- un film de blindage 102 électriquement conducteur comprenant au moins 90% massique de nanofils métalliques,
- une couche de protection 103 en un second matériau polymère.

La structure de blindage électromagnétique 100 pourrait contenir des couches additionnelles. Par exemple, elle pourrait, éventuellement, comprendre deux couches de protection au lieu d'une seule.

Préférentiellement, la structure de blindage 100 est constituée par la couche électriquement isolante 101, le film de blindage 102 et la couche de protection 103.

La structure de blindage électromagnétique 100 a, avantageusement, une transmittance, ou transparence, supérieure à 50 % dans le domaine visible (de 350nm à 750nm), et de préférence supérieure à 70 %. On parle de couche semi-transparente. La structure 100 selon l'invention permet la visualisation des composants contrairement aux structures de blindage de l'art antérieur de type boitiers.

### La couche électriquement isolante 101 :

La couche 101 a pour fonction d'isoler électriquement les composants du support 200 du film de blindage 102 électriquement conducteur. La couche électriquement isolante 101 peut recouvrir une seule zone 201 de composants (figures 1, 2 et 3) ou une pluralité de zones 201 de composants (figures 4 et 5). Elle peut également recouvrir tout le support, excepté la piste de masse 202.

Le polymère formant la couche de protection 101 est, par exemple, un polysiloxane (aussi appelé silicone), un polyacrylique, un polyuréthane ou un polyépoxyde (aussi appelé époxy).

La couche 101 a, par exemple, une épaisseur allant de 1µm à 5000µm et de préférence, une épaisseur allant de 1µm à 1000µm pour recouvrir tout type de composants, de toutes formes géométriques, même ceux présentant des reliefs, et ceux de taille importante.

La couche 101 de polymère a, avantageusement, une transparence ou transmittance supérieure à 70 % dans le domaine visible. Il est possible de visualiser les composants à travers la couche 101, ce qui permet de déposer localement le film de blindage sur la ou les zones à protéger.

### Le film de blindage électromagnétique 102 :

Le film de blindage électromagnétique 102 protège les composants électroniques du support des parasites électromagnétiques. Le film de blindage 102 recouvre sur la zone 201 de composants électroniques à protéger et se prolonge jusqu'à la piste de masse 202, de manière à réaliser une prise de contact sur la piste de masse 202.

Selon un mode de réalisation représenté sur la figure 1, le support 200 n'est pas en contact avec le film de blindage 102, la couche électriquement isolante 101 est interposée entre le support 200 et le film de blindage 102.

Selon une variante représentée à la figure 2, une partie du support 200 peut être en contact avec le film de blindage 102. Cette variante est, avantageusement, réalisée, si la partie du support 200 en contact avec le film de blindage 102 est électriquement isolante et/ou si elle ne comporte pas de composants ou de pistes électriques.

Le film de blindage 102 peut prendre contact sur une partie de la piste de masse 202 (figures 1, 2, 3 et 4) ou sur tout le pourtour du support 200 (figure 5).

La masse surfacique de nanofils est de 10mg/m² à 1000mg/m², et de préférence de 20mg/m² à 400mg/m², et encore plus préférentiellement de 30mg/m² à 50mg/m² pour permettre un blindage efficace tout en étant semi-transparent.

Les nanofils peuvent être des nanofils d'argent, d'or, de nickel ou de cuivre.

Le diamètre moyen des nanofils est, avantageusement, inférieur à 200nm, et, encore plus avantageusement, inférieur à 100nm. Le diamètre des nanofils est, de préférence, de 15nm à 200nm, encore plus préférentiellement de 20nm à 80nm et de manière encore plus préférentielle de 40nm à 80nm. La longueur moyenne des nanofils est, avantageusement, de 1µm à 500µm, de préférence la longueur va de 2µm à 25µm, et encore plus préférentiellement la longueur est de l'ordre de 10µm.

Une représentation schématique d'une couche de nanofils est donnée sur la figure 6. Les nanofils forment un réseau percolant communément appelé «réseau bidimensionnel », c'est-à-dire que les nanofils sont agencés de telle sorte qu'ils permettent le transport d'électrons (système au-dessus du seuil de percolation). Le réseau aléatoire de nanofils métalliques forme des trous.

Le film de blindage 102 a, par exemple, une épaisseur de 20nm à 1000nm, et de préférence de 20nm à 300nm. Il est possible d'avoir localement N nanofils empilés les uns sur les autres. L'épaisseur du film de blindage 102 correspondante est N fois le diamètre des nanofils.

Le film de blindage 102 peut être constitué de nanofils métalliques.

Le film de blindage 102 peut comprendre, en outre, des nanotubes de carbone et/ou du graphène pour améliorer la conductivité électrique.

### La couche de protection 103 :

La couche de protection 103 assure la tenue mécanique des nanofils du film de blindage électromagnétique 102. Elle recouvre le film électromagnétique 102. Elle peut le recouvrir intégralement. Avantageusement, on laissera une accessibilité à la piste de masse 202. La couche de protection n'est pas représentée sur les figures 3 et 4 pour plus de lisibilité.

La couche de protection 103 est en polysiloxane, en polyépoxyde, en polyacrylique ou en polyuréthane. Avantageusement, elle joue le rôle de barrière de diffusion en protégeant les nanofils de l'atmosphère, notamment du dioxygène, et du soufre, ce qui évite leur oxydation ou sulfuration. Les risques de dégradation chimique sont ainsi limités et les performances de blindage électromagnétique améliorées. Elle est, avantageusement, électriquement isolante.

La couche de protection 103 a une épaisseur allant de 1µm à 5000µm et, de préférence, de 1µm à 1000µm, et encore plus préférentiellement de 1µm à 500µm.

La couche de protection 103 est semi-transparente.

Un procédé de réalisation d'une structure de blindage va maintenant être décrit. La structure de blindage électromagnétique 100 est réalisée sur un support comprenant une zone de composants électroniques à protéger 201 et une piste de masse 202.

Lors d'une première étape, la couche électriquement isolante 101 est formée au moins sur la zone de composants électroniques 201.

Lors d'une deuxième étape, le film de blindage 102 électriquement conducteur est formé, par-dessus la couche électriquement isolante 101, sur la zone de composants électroniques 201 et jusqu'à la piste de masse 202.

Le film de blindage 102 est formé en déposant et en séchant une solution contenant des nanofils métalliques et un solvant. Le solvant est, préférentiellement, choisi parmi l'eau, un solvant organique et un de leur mélange. Préférentiellement, le solvant est choisi parmi l'eau, un alcool et un mélange eau/alcool. L'alcool a, par exemple, de 1 à 4 atomes de carbone. Selon une variante, un solvant organique tel que l'acétone, la méthyléthylcétone, le diméthylsufoxyde, le n-méthylpyrrolidone, le cyclohexane, ou le pentane, est utilisé.

Préférentiellement, les nanofils métalliques représentent de 0.01 % à 50 % massique de la solution, plus préférentiellement, ils représentent de 0.1 % à 20 % massique et, encore plus préférentiellement, de 0.5 % à 10 % massique de la solution. En fonction de la concentration massique utilisée, et des conditions de dépôt » (débit, vitesse, etc), il est possible de réaliser, en un seul dépôt, un film de blindage électromagnétique comprenant une ou plusieurs épaisseurs de nanofils.

Le film de blindage électromagnétique 102 peut être formé localement sur la zone de composants électroniques 201, par exemple, à travers un masque dont les orifices laissent accessibles les zones 201 d'intérêt ou par dépôt par pulvérisation localisé.

Le procédé comprend une troisième étape dans laquelle une couche de protection 103 est formée sur le film de blindage 102.

La couche électriquement isolante 101 et/ou la couche de protection 103 sont, avantageusement, formées par voie liquide. Par exemple, la couche électriquement isolante 101 et la couche de protection 103 sont formées par dépôt et séchage d'une solution contenant un polymère, avantageusement, dispersé dans un solvant.

Selon une variante, le matériau polymère, en solution, est remplacé par un précurseur du matériau polymère associé à un initiateur de polymérisation. Par précurseur du matériau polymère, on entend des monomères et/ou des oligomères et/ou des pré-polymères menant à la formation du polymère. L'initiateur de polymérisation est, par exemple, un photoinitiateur ou un amorceur radicalaire. Les couches 101 et 103 sont formées en déposant, polymérisant et séchant la solution.

Ces couches sont, de préférence, déposées par une technique de dépôt sans contact. Le dépôt sans contact évite de toucher les composants du support 200, qui peuvent présenter des hauteurs très variées, en particulier au moment de la réalisation de la couche électriquement isolante 101. Il peut s'agir, par exemple, d'un dépôt par pulvérisation (« spray coating ») ou encore de toute technique d'enduction, telle que l'enduction en rideau (« curtain coating » ou « flow-coating ») ou l'enducation centrifuge (« spin-coating »).

Le procédé est, avantageusement, réalisé à température ambiante et à pression ambiante. Le procédé est, avantageusement, réalisé sous air, il n'y a pas besoin de travailler sous atmosphère contrôlée.

Il est, néanmoins, possible de chauffer légèrement le substrat (jusqu'à 100°C maximum et de préférence jusqu'à 70°C maximum) lors du dépôt des couches 101 et 103 ou lors du dépôt du film de blindage 102.

### EXEMPLE ILLUSTRATIF ET NON LIMITATIF D'UN MODE DE REALISATION

Le support 200 est une carte électronique, comprenant une zone d'intérêt à protéger 201 et un anneau de garde 202. La carte électronique est préalablement nettoyée.

Une couche en polyacrylique est déposée sur la carte électronique par dépôt à la tournette (« spin coating ») pour former la couche isolante 101. Il s'agit d'un vernis électriquement isolant et transparent commercialisé par la société 3M sous la références Scotch® 1601. Une étape de séchage est réalisée à 90°C pendant 60s afin d'évaporer les traces de solvant résiduelles.

Les zones ne contenant pas de composants électroniques à protéger sont recouvertes d'un masque. Le masque est formé d'adhésifs plastifiés et de cordons en silicone.

Une solution de méthanol contenant des nanofils d'argent (400 mg/L), élaborées comme dans la publication intitulée « Improvements in purifiation of silver nanowires by decantation and fabrication of flexible transparent electrodes. Application to capacitive touch sensors », Céline Mayousse et al., Nanotechnology 2013, 24, 215501, est ensuite déposée à travers le masque par nébulisation pour former le film de blindage 102. Le dépôt est réalisé avec une densité surfacique de nanofils de 75 mg/m² (mesurée par absorption atomique). Le dépôt de nanofils d'argent est réalisé sur la zone de composants à protéger et déporté jusqu'à l'anneau de garde permettant la mise à la masse du film de blindage.

Après séchage pendant 30 minutes à 50°C, les protections sont enlevées.

Une résine polysiloxane, commercialisée par la société Isochem, sous la référence Varnish 300-1, est diluée dans du n-butanol, et déposée par pulvérisation sur les nanofils. Elle est ensuite chauffée à 70 °C durant 2 heures, pour former la couche de protection 103. L'épaisseur de la couche de protection 103 est d'environ 3 µm.

L'ensemble des trois couches 101, 102, 103 présente une transmittance globale de 72 % dans le spectre visible, ce qui permet de visualiser aisément l'ensemble des éléments présents sur la carte électronique.

Une structure de blindage électromagnétique 100 a été formée sur un substrat en verre afin d'estimer l'atténuation des ondes électromagnétiques. Les mesures ont été réalisées dans une chambre anéchoïque. L'échantillon est positionné à environ 10cm d'un émetteur et à environ 80cm d'un récepteur. Il a été mesuré une atténuation du signal (S21) de plus de 30 dB sur l'ensemble de la gamme 100 MHz- 20 GHz.

## Revendications

1. Structure de blindage électromagnétique (100) comprenant successivement :
- une couche électriquement isolante (101) en un premier matériau polymère,
- un film de blindage (102) électriquement conducteur comprenant au moins 90% massique de nanofils métalliques,
- une couche de protection (103) en un second matériau polymère, **caractérisé en ce que** le film de blindage (102) est constitué de nanofils métalliques, et, éventuellement, de nanotubes de carbone et/ou de graphène.

2. Structure (100) selon la revendication 1, **caractérisée en ce que** la masse surfacique de nanofils est de 10mg/m² à 1000mg/m², et de préférence de 20mg/m² à 400mg/m², et encore plus préférentiellement de 30mg/m² à 50mg/m².

3. Structure (100) selon l'une des revendications 1 et 2, **caractérisée en ce que** les nanofils sont des nanofils d'argent, d'or, de nickel ou de cuivre.

4. Structure (100) selon l'une quelconque des revendications précédentes, **caractérisée en ce que** le diamètre moyen des nanofils est inférieur à 200nm, et de préférence inférieur à 100 nm, la longueur moyenne des nanofils étant de 1µm à 500µm.

5. Structure (100) selon l'une quelconque des revendications précédentes, **caractérisée en ce que** le film de blindage (102) a une épaisseur allant de 20nm à 1000nm et de préférence de 20nm à 300nm.

6. Structure (100) selon l'une quelconque des revendications précédentes, **caractérisée en ce que** la structure de blindage électromagnétique (100) a une transmittance supérieure à 50 % dans le domaine visible, et de préférence supérieure à 70%.

7. Structure (100) selon l'une quelconque des revendications précédentes, **caractérisée en ce que** la couche électriquement isolante (101) et la couche de protection (103) ont une épaisseur allant de 1µm à 5000µm, et de préférence, de 1µm à 1000µm.

8. Structure (100) selon l'une quelconque des revendications précédentes, **caractérisée en ce que** le premier matériau polymère est choisi parmi un polysiloxane, un polyépoxyde, un polyacrylique et un polyuréthane ou **en ce que** le second matériau polymère est choisi parmi un polysiloxane, un polyépoxyde, un polyacrylique et un polyuréthane.

9. Structure de blindage électromagnétique (100) selon l'une quelconque des revendications précédentes, **caractérisée en ce qu'**elle est constituée successivement par :
- la couche électriquement isolante (101),
- le film de blindage (102),
- la couche de protection (103).

10. Support (200), telle qu'une carte électronique, comprenant une zone de composants électroniques à protéger (201) et une piste de masse (202), recouvert par une structure (100) telle que définie dans l'une quelconque des revendications 1 à 9,
la couche électriquement isolante (101) recouvrant au moins la zone de composants électroniques (201) à protéger,
le film de blindage électromagnétique (102) étant disposé sur la zone de composants électroniques (201) et se prolongeant jusqu'à la piste de masse (202), de manière à réaliser une prise de contact sur la piste de masse (202), le film de blindage électromagnétique (102) étant électriquement isolé de la zone de composants électroniques à protéger (201) par la couche électriquement isolante (101),
la couche de protection (103) recouvrant le film de blindage (102).

11. Procédé de réalisation d'une structure de blindage électromagnétique (100), selon l'une quelconque des revendications 1 à 9, sur un support (200) comprenant une zone de composants électroniques à protéger (201) et une piste de masse (202), ledit procédé comprenant au moins les étapes successives suivantes :
a) fourniture d'un support (200) comprenant une zone de composants électroniques à protéger (201) et une piste de masse (202),
b) formation d'une couche électriquement isolante (101) en un premier matériau polymère au moins sur la zone de composants électroniques (201),
c) formation d'un film de blindage (102) électriquement conducteur comprenant au moins 90% massique de nanofils métalliques sur la zone de composants électroniques à protéger (201) et jusqu'à la piste de masse (202), le film de blindage (102) étant constitué de nanofils métalliques, et éventuellement, de nanotubes de carbone et/ou de graphène,
la formation du film (102) étant réalisée par dépôt et séchage d'une solution contenant les nanofils métalliques, et éventuellement les nanotubes de carbone et/ou le graphène, et un solvant,
d) formation d'une couche de protection (103) en un second matériau polymère sur le film de blindage (102).

12. Procédé selon la revendication précédente, **caractérisé en ce que** la couche électriquement isolante (101) et la couche de protection (103) sont formées par une technique de dépôt sans contact, tel qu'un dépôt par pulvérisation ou par enduction en rideau.

13. Procédé selon l'une quelconque des revendications 11 et 12, **caractérisé en ce que** la couche électriquement isolante (101) a une transmittance supérieure à 70 % dans le domaine visible.

14. Procédé selon l'une quelconque des revendications 11 à 13, **caractérisé en ce que** le film de blindage (102) est formé à travers un masque ou par dépôt par pulvérisation localisé.

15. Procédé selon l'une quelconque des revendications 11 à 14, **caractérisé en ce que** le procédé est réalisé à température ambiante et à pression ambiante.

## Patentansprüche

1. Elektromagnetische Abschirmungsstruktur (100), die aufeinanderfolgend enthält:
- eine elektrisch isolierende Schicht (101) aus einem ersten Polymermaterial,
- eine elektrisch leitfähige Abschirmungsfolie (102), die mindestens 90 Masse-% Metall-Nanodrähte enthält,
- eine Schutzschicht (103) aus einem zweiten Polymermaterial,
**dadurch gekennzeichnet, dass** die Abschirmungsfolie (102) aus Metall-Nanodrähten und gegebenenfalls aus Nanoröhrchen aus Kohlenstoff und/oder Graphen besteht.

2. Struktur (100) nach Anspruch 1, **dadurch gekennzeichnet, dass** die Nanodraht-Oberflächenmasse 10 mg/m² bis 1000 mg/m², und vorzugsweise 20 mg/m² bis 400 mg/m², und noch bevorzugter 30 mg/m² bis 50 mg/m² beträgt.

3. Struktur (100) nach einem der Ansprüche 1 und 2, **dadurch gekennzeichnet, dass** die Nanodrähte Silber-, Gold-, Nickel- oder Kupfer-Nanodrähte sind.

4. Struktur (100) nach einem der vorhergehenden Ansprüche, **dadurch gekennzeichnet, dass** der mittlere Durchmesser der Nanodrähte weniger als 200 nm und vorzugsweise weniger als 100 nm beträgt, wobei die mittlere Länge der Nanodrähte 1 µm bis 500 µm beträgt.

5. Struktur (100) nach einem der vorhergehenden Ansprüche, **dadurch gekennzeichnet, dass** die Abschirmungsfolie (102) eine Dicke im Bereich von 20 nm bis 1000 nm und vorzugsweise von 20 nm bis 300 nm aufweist.

6. Struktur (100) nach einem der vorhergehenden Ansprüche, **dadurch gekennzeichnet, dass** die elektromagnetische Abschirmungsstruktur (100) einen Transmissionsgrad von mehr als 50 % im sichtbaren Bereich, vorzugsweise von mehr als 70 %, aufweist.

7. Struktur (100) nach einem der vorhergehenden Ansprüche, **dadurch gekennzeichnet, dass** die elektrisch isolierende Schicht (101) und die Schutzschicht (103) eine Dicke im Bereich von 1 µm bis 5000 µm, vorzugsweise von 1 µm bis 1000 µm, aufweisen.

8. Struktur (100) nach einem der vorhergehenden Ansprüche, **dadurch gekennzeichnet, dass** das erste Polymermaterial ausgewählt ist aus Polysiloxan, Polyepoxid, Polyacryl und Polyurethan, oder dass das zweite Polymermaterial ausgewählt ist aus Polysiloxan, Polyepoxid, Polyacryl und Polyurethan.

9. Elektromagnetische Abschirmungsstruktur (100) nach einem der vorhergehenden Ansprüche, **dadurch gekennzeichnet dass** sie aufeinanderfolgend besteht aus:
- der elektrisch isolierenden Schicht (101),
- der Abschirmungsfolie (102),
- der Schutzschicht (103).

10. Träger (200), wie etwa Leiterplatte, der einen Bereich von zu schützenden elektronischen Komponenten (201) und eine Massebahn (202) enthält und von einer Struktur (100) nach einem der Ansprüche 1 bis 9 bedeckt ist,
wobei die elektrisch isolierende Schicht (101) mindestens den Bereich der zu schützenden elektronischen Komponenten (201) bedeckt,
wobei die elektromagnetische Abschirmungsfolie (102) auf dem Bereich der elektronischen Komponenten (201) angeordnet ist und sich bis zur Massebahn (202) erstreckt, um mit der Massebahn (202) in Kontakt zu gelangen, wobei die elektromagnetische Abschirmungsfolie (102) von dem Bereich der zu schützenden elektronischen Komponenten (201) durch die elektrisch isolierende Schicht (101) elektrisch isoliert ist,
wobei die Schutzschicht (103) die Abschirmungsfolie (102) bedeckt.

11. Verfahren zum Herstellen einer elektromagnetischen Abschirmungsstruktur (100) nach einem der Ansprüche 1 bis 9 auf einem Träger (200), der einen Bereich mit zu schützenden elektronischen Komponenten (201) und eine Massebahn (202) aufweist, wobei das Verfahren mindestens die nachstehenden, aufeinanderfolgenden Schritte umfasst:
a) Bereitstellen eines Trägers (200), der einen Bereich mit zu schützenden elektronischen Komponenten (201) und eine Massebahn (202) enthält,
b) Ausbilden einer elektrisch isolierenden Schicht (101) aus einem ersten Polymermaterial zumindest auf dem Bereich mit den elektronischen Komponenten (201),
c) Ausbilden einer elektrisch leitfähigen Abschirmungsfolie (102), die zu mindestens 90 Gew.-% aus Metall-Nanodrähten besteht, auf dem Bereich mit den zu schützenden elektronischen Komponenten (201) und bis zur Massebahn (202),
wobei die Abschirmungsfolie (102) aus Metall-Nanodrähten und gegebenenfalls aus Nanoröhrchen aus Kohlenstoff und/oder Graphen besteht, wobei die Folie (102) durch Abscheiden und Trocknen einer Lösung gebildet wird, die die Metall-Nanodrähte und gegebenenfalls die Nanoröhrchen aus Kohlenstoff und/oder Graphen und ein Lösungsmittel enthält,
d) Ausbilden einer Schutzschicht (103) aus einem zweiten Polymermaterial auf der Abschirmungsfolie (102).

12. Verfahren nach dem vorhergehenden Anspruch, **dadurch gekennzeichnet, dass** die elektrisch isolierende Schicht (101) und die Schutzschicht (103) durch eine berührungslose Abscheidungstechnik, wie Sputtern oder Vorhangbeschichtung, ausgebildet werden.

13. Verfahren nach einem der Ansprüche 11 und 12, **dadurch gekennzeichnet, dass** die elektrisch isolierende Schicht (101) einen Transmissionsgrad von mehr als 70 % im sichtbaren Bereich aufweist.

14. Verfahren nach einem der Ansprüche 11 bis 13, **dadurch gekennzeichnet, dass** die Abschirmungsfolie (102) durch eine Maske hindurch oder durch lokalisierte Sputterabscheidung ausgebildet wird.

15. Verfahren nach einem der Ansprüche 11 bis 14, **dadurch gekennzeichnet, dass** das Verfahren bei Umgebungstemperatur und Umgebungsdruck durchgeführt wird.

## Claims

1. An electromagnetic shielding structure (100) successively comprising:
- an electrically insulating layer (101) of a first polymeric material,
- an electrically conductive shielding film (102) comprising at least 90 mass % of metal nanowires,
- a protective layer (103) of a second polymeric material, **characterized in that** the shielding film (102) consists of metal nanowires, and, optionally, carbon nanotubes and/or graphene.

2. The structure (100) according to claim 1, **characterized in that** the mass per unit area of the nanowires is from 10 mg/m² to 1000 mg/m², and preferably from 20 mg/m² to 400 mg/m², and even more preferably from 30 mg/m² to 50 mg/m².

3. The structure (100) according to one of claims 1 and 2, **characterized in that** the nanowires are silver, gold, nickel or copper nanowires.

4. The structure (100) according to any one of the preceding claims, **characterized in that** the mean nanowire diameter is lower than 200 nm, and preferably lower than 100nm, the mean nanowire length being from 1 µm to 500 µm.

5. The structure (100) according to any one of the preceding claims, **characterized in that** the shielding film (102) has a thickness ranging from 20 nm to 1 000 nm and preferably from 20 nm to 300 nm.

6. The structure (100) according to any one of the preceding claims, **characterized in that** the electromagnetic shielding structure (100) has a transmittance higher than 50 % in the visible region, and preferably higher than 70%.

7. The structure (100) according to any one of the preceding claims, **characterized in that** the electrically insulating layer (101) and the protective layer (103) have a thickness ranging from 1 µm to 5 000 µm, preferably from 1 µm to 1000 µm.

8. The structure (100) according to any one of the preceding claims, **characterized in that** the first polymeric material is chosen from a polysiloxane, a polyepoxide, a polyacrylic and a polyurethane or **in that** the second polymeric material is chosen from a polysiloxane, a polyepoxide, a polyacrylic and a polyurethane.

9. The structure (100) according to any one of the preceding claims, **characterized in that** it is constituted of successively:
- the electrically insulating layer (101),
- the shielding film (102),
- the protective layer (103).

10. A support (200), such as an electronic board, comprising a zone of electronic components to be protected (201) and a ground track (202), covered with a structure (100) as defined in any one of claims 1 to 9,
the electrically insulating layer (101) covering at least the zone of electronic components (201) to be protected,
the electromagnetic shielding film (102) being disposed on the zone of electronic components (201) and being extended to the ground track (202), so as to make contact with the ground track (202), the electromagnetic shielding film (102) being electrically insulated from the zone of electronic components to be protected (201) by the electrically insulating layer (101),
the protective layer (103) covering the shielding film (102).

11. A method for making an electromagnetic shielding structure (100), according to any one of claims 1 to 9, on a support (200) comprising a zone of electronic components to be protected (201) and a ground track (202), said method comprising at least the following successive steps of:
a) providing a support (200) comprising a zone of electronic components (201) to be protected and a ground track,
b) forming an electrically insulating layer (101) of a first polymeric material at least on the zone of electronic components (201),
c) forming an electrically conductive shielding film (102) comprising at least 90 mass % of metal nanowires on the zone of electronic components to be protected (201) and up to the ground track (202),
the shielding film (102) consisting of metal nanowires, and, optionally, carbon nanotubes and/or graphene,
the formation of the shielding film (102) being made by depositing and drying a solution comprising the metal nanowires, and optionally carbon nanotubes and/or graphene, and a solvent,
d) forming a protective layer (103) of a second polymeric material on the shielding film (102).

12. The method according to the preceding claim, **characterized in that** the electrically insulating layer (103) and the protective layer (103) are formed by a contactless deposition technique, such as spraying deposition or curtain coating.

13. The method according to one of claims 11 and 12, **characterized in that** the electrically insulating layer (101) has a transmittance higher than 70% in the visible region.

14. The method according to any one of claims 11 to 13, **characterized in that** the shielding film (102) is formed through a mask or by a localised spraying deposition.

15. The method according to any one of claims 11 to 14, **characterized in that** the method is performed at ambient temperature and ambient pressure.
